# EUROPEAN PATENT APPLICATION

(11) **EP 4 407 065 A1**
(43) Date of publication of application: **31.07.2024**
(21) Application number: 23153748.1
(22) Date of filing: 27.01.2023
(51) Int. Cl.: C23C 14/00, C23C 14/02, C23C 14/06, H01L 33/00, C30B 25/06, C30B 25/18

(54) **DEPOSITION OF ALN ON A SILICON SUBSTRATE AND GAN SEMICONDUCTOR TRANSITION LAYER STRUCTURE**

(71) Applicant: Epinovatech AB, 223 63 Lund (SE)
(72) Inventor: OLSSON, Martin Andreas, 223 63 Lund (SE)
(74) Representative: Zacco Sweden AB

(57) **Abstract**

The present invention relates to a method for depositing AIN on a silicon substrate arranged in a process chamber. The method comprises: arranging an aluminum target in said process chamber; providing a process gas composition comprising a noble gas and nitrogen to said process chamber; ionizing said process gas composition by providing an electric field and a magnetic field such that a getter of noble gas ions and nitrogen ions is formed; sputtering said aluminum target while applying a positive bias on the silicon substrate; and depositing an epilayer of aluminum and nitrogen on the silicon substrate. The present invention further relates to a gallium nitride semiconductor transition layer structure comprising a AIN epilayer obtained by the method.

## Description

### Technical field

The present invention relates to methods of depositing aluminum-nitride (AIN) on silicon substrate.

### Background

The material gallium nitride (GaN) does not exist naturally in nature, but can be formed from its constituents gallium and nitrogen. Gallium nitride (GaN) can be deposited by means of MOCVD, on a substrate that is close to lattice-matched to the in-plane lattice parameter of GaN i.e. 3.1 Å. In order to provide GaN on silicon typically aluminum nitride is deposited as a primer or nucleation layer. A common substrate used in LED production is sapphire that has a lattice-mismatch of 30% to GaN, but so far the wafer sizes of sapphire has been limited to wafer sizes below 8-inch, whereas silicon wafer sizes of 12-inch size is conventional and abundant to the semiconductor industry. Hence, depositing gallium nitride on silicon would be an industrially scalable approach on 4-12 inch wafers.

Deposition of aluminum-nitride (AIN) may be performed in a variety of ways. Among these, metalorganic vapor deposition (MOCVD), magnetron sputtering and atomic layer deposition (ALD) may be mentioned. So far, out of these techniques, mainly MOCVD provide epitaxial crystalline quality, i.e. an XRD FWHM of better than 0.1° of AIN on 4-8 inch wafers.

It is one object of the invention to provide AIN-on-Silicon by sputtering for GaN-on-Silicon epiwafers. The issues and challenges of providing GaN-on-Silicon and the use of AIN on silicon in the prior art will be described in the following.

The Si (111) substrate plane for epitaxial aluminum nitride is usually chosen due to its trigonal symmetry favoring epitaxy of a hexagonal wurtzite GaN structure. During MOCVD epitaxial growth of GaN-on-Silicon the Ga may alloy with the silicon referred to as Ga melt back. Pure gallium (Ga) is a melt at room temperature with a melting point of 29.8°C whereas the melting point of silicon is 1410°C. Due to the Gibbs free energy of mixing of gallium (Ga) and silicon (Si) to form an alloy, the melting point of the Ga-Si alloy is very close to the melting point of Ga and may be as low as 100°C. During MOCVD growth of GaN directly on Silicon at 1100°C, diffusion of Ga into the silicon takes place causing a Ga-Si melt at the process temperature. This is called gallium melt back.

Many other materials than AIN has been used as nucleation layer or transition layers to isolate GaN from Si, such as SiC, HfN, ZnO, Al₂O₃, or rare earth oxides or nitrides.

Furthermore, during MOCVD growth of AIN on Silicon as a nucleation layer, it is necessary to avoid the formation of silicon nitride. Al pretreatment or preflow is used to wet the Si surface without the introduction of ammonia (NH₃) to prevent the formation of an amorphous SiNx layer. However, an amorphous thin layer of SiNₓ can still exist at the Si-AIN interface due to the reaction between N and the Si substrate.

The conditions for TMAI preflow are significant in affecting the Si-AIN interface, which can determine the structural quality, surface morphology, and surface pits in the AIN layer and the subsequently grown GaN layers.

In order to avoid the Si-Al eutectic temperature, the quality of the AIN nucleation layer may be poor with a thickness below 50 nm.

Significant tensile thermal stress during cool-down results in concave bending of Si wafer and cracks in the GaN epilayers due to the large difference (54%) in thermal expansion coefficient.

In order to compensate for the large tensile thermal stress that occurs during growth of GaN-on-Si, some compressive stress can be intentionally built-in to a subsequent GaN epilayer on AIN-on-Silicon during epitaxy by lattice-mismatch-induced strain. The MOCVD growth of AIN epilayer deposited on and above a silicon (111) substrate causes tensile stress as the lattice constants has the relationship *a_{epilayer} < a_{substrate}* where *a_{AlN}* is 3.110Å, and *a_{Si}* is 3.84Å hence the AIN epilayer is tensile and providing a wafer curvature that is concave. However, the subsequent growth of MOCVD growth of GaN epilayer on AIN as a substrate causes compressive stress in the epilayer as the lattice constants has the relationship *a_{epilayer}* > *a_{substrate}* where *a_{GaN}* is 3.189Å and *a_{AlN}* is 3.110Å, hence the GaN epilayer is compressive and providing a wafer curvature that is convex. Therefore, the deposition of MOCVD AIN typically starts with a silicon (111) substrate that is first annealed at 1050 °C under H2 ambient for about 5-10 min to remove the native oxide layer. Then 50-150 Imol/min of TMAI is introduced into reactor for 5-15 s at temperature of 600-900°C without the presence of NH3 to prevent the formation of amorphous SiNx layer. Then a 100 nm AIN nucleation layer is deposited. Growth of AIN is carried out at temperature above 1000 °C under H2 ambient at a pressure of 75 Torr to minimize parasitic reactions between TMAI and NH3. Such is described in Papasouliotis et al., J. Mater. Res., Vol. 30, No. 19, Oct 14, 2015.

A main hindrance to the development of AIN-on-Silicon is the low growth rate. The reported growth rate of AIN layer on Si by MOCVD is ~150 nm/h whereas the thickness of AIN base layer used as template for GaN growth generally needs to be ~300 nm with a process time of ~2h. Such is described by Xianglin Liu et al., Scientific reports 4 : 6416.

### Summary

In view of the above, an object of the present invention is to provide an improved method of depositing an epitaxial AIN epilayer on silicon. Embodiments of the present invention preferably seek to mitigate, alleviate or eliminate one or more deficiencies, disadvantages or issues in the art, such as the above described, singly or in any combination by providing a method for depositing AIN on a silicon substrate arranged in a process chamber according to the appended patent claims.

It should be emphasized that the term "comprises/comprising" when used in this specification is taken to specify the presence of stated features, integers, steps or components but does not preclude the presence or addition of one or more other features, integers, steps, components or groups thereof.

Precursor gases that are metalorganic and thermally decomposed contaminates the epitaxial AIN layer with carbon atoms. This forms a parasitic conductive channel in the silicon substrate leading to switching losses in high-speed RF devices and reduces the breakdown voltage of GaN power devices. Thus, it is an object of the present invention to provide a method of depositing a carbon-free, epitaxial AIN epilayer on silicon.

Another object of the invention is to provide an epitaxial AIN epilayer that can build in stress into a gallium nitride layer arranged above the AIN epilayer, such that the AIN epilayer may serve as a barrier for Ga melt-back.

It is further another object of the invention to provide a carbon-free aluminum nitride on silicon with improved electrical characteristics of the silicon-aluminum nitride interface.

Aluminum nitride has the largest bandgap of all semiconductors such that it is close to an insulator. During sputtering, the surface of aluminum nitride becomes charged by the ion bombardment, which increases the risk of plasma arcing. It is thus another object of the invention to provide a smooth low surface roughness aluminum nitride thin-film on silicon that is epitaxially aligned.

To achieve at least these objects and also other objects that will be evident from the following description, a method having the features defined in claim 1 and a gallium nitride semiconductor transition layer structure having the features defined in claim 16 is provided according to the present invention. Preferred embodiments will be evident from the dependent claims.

Any benefit or technical effect discussed in relation any aspect of the present invention, and any embodiments thereof, may be applicable to any other aspect of the present invention.

According to a first aspect of the present invention, a method for depositing AIN on a silicon substrate arranged in a process chamber is provided, the method comprising: arranging an aluminum target in the process chamber; providing a process gas composition comprising a noble gas and nitrogen to the process chamber; ionizing the process gas composition by providing an electric field and a magnetic field such that a getter of noble gas ions and nitrogen ions is formed; sputtering the aluminum target while applying a positive bias on the silicon substrate; and depositing an epilayer of aluminum and nitrogen on the silicon substrate.

By applying a positive bias on the silicon substrate, negatively charged ions as well as electrons are attracted to the substrate. Hereby, the glow discharge is displaced towards the silicon substrate. Thus, the growth of AIN on the silicon substrate is promoted.

The epilayer of aluminum and nitrogen will have an epitaxial relationship with the silicon substrate. The term 'epitaxial relationship' shall be understood as in-plane orientation between two crystalline materials. For example, the epitaxial relationship between *AlN* (0001) and *Si*(111) is *AlN* [1120̅] // *Si*[110̅] and *AlN* [110̅0] // *Si*[112̅] and that of GaN and AlN is *GaN* [1120̅] // *AlN* [1120̅] and *GaN* [110̅0] // *AlN* [110̅0].

The positive bias on the silicon substrate may be set in accordance with a desired speed of formation of a AIN, and/or a desired thickness of such a layer.

The positive bias may be in the range from and including 1 kV to and including 5 kV. The positive bias may as such be 1 kV, or 2 kV, or 3 kV, or 4 kV, or 5 kV.

The positive bias may be applied as a DC bias.

The DC bias may be applied with a power in the range of 900 to 1500 W.

The DC bias may be pulsed with a frequency in a range from and including 10 kHz to and including 350 kHz.

The duty cycles may be in a range from and including 1% to and including 10%.

The silicon substrate may be any type of silicon. Preferably, the silicon substrate has a crystallographic direction of <111>.

The silicon substrate and the aluminum target may be substantially parallel and arranged at a distance in a range from and including 1 to and including 10 cm from each other.

The process gas composition may comprise any gas. Further, the process gas composition may comprise any combination of noble gases. For example, the process gas composition may comprise argon, and/or helium, and/or neon, etc. Preferably, the process gas composition comprises argon. For example, the process gas composition may comprise argon, and wherein a ratio of nitrogen to argon is in the range of 1:1 to 1:3.

A total pressure in the process chamber during sputtering may be less than 7.5 mTorr (1 Pa). Hereby, the rate of ionization of the process gas composition increases. Thus, the rate of sputtering, and therefore the rate of deposition of the aluminum and nitrogen increases.

The inventor has further realized that if the partial pressures of argon, *p_{Ar},* and nitrogen, *p*_{*N*2}, in the glow discharge formed in the process chamber during sputtering satisfies the relationship of argon, p_{Ar}, is 0.1 mTorr < p_{Ar} < 3 mTorr and the partial pressure of nitrogen, is 0.2 < p_{N2} < 0.3 mTorr, a surprising promotion of the growth of AIN epilayer on the silicon substrate is achieved where the AIN has a rod structure and the AIN epilayer is compressive.

Ionizing the process gas composition by providing an electric field and a magnetic field can be achieved by any suitable means, preferably by a magnetron. The magnetic field may e.g. be provided substantially perpendicular to a plane of extension of the aluminum target.

Prior to depositing a getter of aluminum and nitride on the silicon substrate, the silicon substrate may be surface treated so as to increase the surface smoothness thereof. For example, the method may further comprise sputtering the silicon substrate by the noble gas before sputtering the aluminum target. Alternatively, the method may further comprise wet etching the silicon substrate in HF prior to the silicon substrate being arranged in the process chamber.

A time between sputtering the silicon substrate or wet etching the silicon substrate and depositing a getter of aluminum and nitrogen on the silicon substrate is less than 20 minutes.

The method may comprise heating the substrate to a substrate temperature in the range of 600 to 1200 °C.

According to a second aspect of the present invention, a gallium nitride semiconductor transition layer structure is provided, the structure comprising: a silicon substrate having a crystallographic direction of <111>; a polycrystalline epilayer of aluminum and nitrogen disposed on and above the silicon substrate by a method according to the first aspect of the present invention; wherein the polycrystalline AIN epilayer comprises a pillar nanostructure having an epitaxial relationship to the substrate.

The epilayer of aluminum and nitrogen may comprise a first 3C-AIN epilayer of a thickness less than 5 nm in direct contact with the silicon substrate, and a 2H-AIN epilayer with a thickness in the range of 100 - 500 nm in direct contact with the 3C-AIN epilayer.

The pillar nanostructure may have a thickness in the range of 10 - 60 nm.

### Brief description of the drawings

These and other embodiments of the present invention will now be described in more detail, with reference to the appended drawings showing exemplary embodiments of the present invention, wherein:

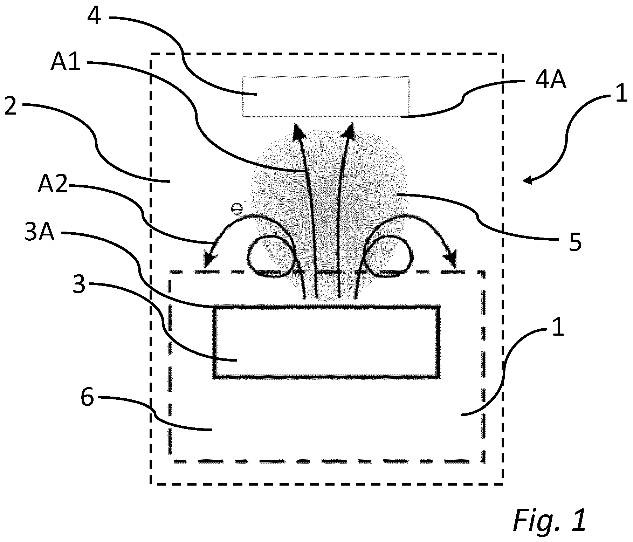

Fig. 1 is a schematic view of a system for performing the method according to the first aspect of the present invention.

### Detailed description of the drawings

In the following detailed description, some embodiments of the present invention will be described. However, it is to be understood that features of the different embodiments are exchangeable between the embodiments and may be combined in different ways, unless anything is specifically indicated. Even though in the following description, numerous details are set forth to provide a more thorough understanding of the present invention, it will be apparent to one skilled in the art that the present invention may be practiced without these details. In other instances, well known constructions or functions are not described in detail, so as not to obscure the present invention. In the drawings, similar or corresponding features are indicated by the same reference number. Before describing the invention in detail herein, it is to be understood that the invention is not limited to any embodiment of GaN-on-Silicon.

Fig. 1 shows a system 1 for depositing AIN according to the first aspect of the present invention. The system 1 comprises a process chamber 2. A process chamber 2 may be any type of chamber configured for sputtering processes. Specifically, the process chamber 2 should preferably be configured to create and maintain a vacuum of 1 to 10 mTorr, and a temperature larger than 500 °C.

The system 1 further comprises an aluminum target 3 and a silicon substrate 4 arranged in the process chamber 2. The aluminum target 3 may e.g. be provided in the form of metallic aluminum. Alternatively, the aluminum target 3 may be provided in the form of an aluminum alloy.

The silicon substrate may have any crystallographic direction. Preferably, the silicon substrate has a crystallographic direction of <111>.

The silicon substrate 4, when arranged in the process chamber 2, may be heated.

Here, the aluminum target 3 and the silicon substrate 4 are displayed as being substantially parallel to each other.

That the aluminum target 3 and the silicon substrate 4 are substantially parallel entails that a main sputtering surface 3A of the aluminum target 3, which faces a main deposition surface 4A of the silicon substrate 4, is substantially parallel to said main deposition surface 4A. Furthermore, the aluminum target 3 and the silicon substrate 4 are substantially coaxial. Since the aluminum target 3 and the silicon substrate 4 are substantially parallel and coaxial, the rate of deposition is maximized.

The main sputtering surface 3A of the aluminum target 3 and the main deposition surface 4A of the silicon substrate 4 may be arranged at a distance of 1 to 30 cm, or 1 to 20 cm, or 1 to 30 cm from each other. Preferably, the main sputtering surface 3A and the main deposition surface 4A are arranged at a distance in a range from and including 1 cm to and including 10 cm from each other.

Prior to sputtering, a process gas composition is provided to the chamber 2. The process gas composition comprises a noble gas and nitrogen. Preferably, the noble gas is argon. Furthermore, the process gas composition may comprise more than one noble gas. For example, the process gas composition may comprise argon and neon. A ratio of argon to neon in the process gas composition may e.g. be 1:1. A partial pressure of nitrogen may be in the range of 0.3 to 0.8 mTorr and a partial pressure of argon may be in the range of 0.8 mTorr to 1.2 mTorr. In one embodiment of the invention the process gas composition, when provided to said process chamber, may have a total pressure of less than 2 mTorr. The total pressure when the process gas composition has been injected into the process chamber 2 may e.g. be 1-10 mTorr. As such, the total pressure of the process gas composition may be 1 mTorr, or 2 mTorr, or 3 mTorr, or 4 mTorr, or 5 mTorr, or 6 mTorr, or 7 mTorr, or 8 mTorr, or 9 mTorr, or 10 mTorr. In another embodiment of the invention, the process gas composition may comprise argon, and the ratio of nitrogen to argon may be in the range of 1:1 to 1:3. The process gas composition may comprise argon, wherein a partial pressure of nitrogen may be in the range of 0.2 to 0.3 mTorr and a partial pressure of argon is in the range of 0.1 mTorr to 3 mTorr. Furthermore, a ratio of nitrogen to argon may be in the range 1:2 and 1:3.

As is well established in the art, in order to initiate sputtering, a negative bias is applied on the aluminum target 3. Positive noble gas ions naturally occurring in the process gas composition, such as argon ions, will therefore be accelerated towards the aluminum target 3, such that the aluminum target 3 target is sputtered. A general direction of travel for an aluminum atom sputtered from the aluminum target 3 is indicated by the arrow A1.

The sputtering of the aluminum target 3 will also lead to emission of secondary electrons. Thus, a glow discharge 5 will be formed. The glow discharge 5 comprises aluminum ions and nitrogen ions.

To increase the rate of sputtering, the process gas composition is ionized by providing an electric field and a magnetic field, such that a getter of noble gas ions and nitrogen ions is formed. The magnetic field may e.g. be substantially parallel to a plane of extension of the target. To this end, the system 1 may further comprises a magnetron 6, as is well established in the art. This causes secondary electrons to move in a circular pattern, which increases ionization of noble gas atoms. The circular pattern is indicated by the arrow A2, which is also denoted by "e⁻".

During sputtering of the aluminum target, a positive bias is applied on the silicon substrate 3. By applying a positive bias on the silicon substrate 3, the glow discharge 5, and therefore the getter of noble gas ions and nitrogen ions, is displaced towards the silicon substrate 3. Thus, aluminum ions and nitrogen ions are attracted to the silicon substrate 3. Thus, the getter of aluminum ions and nitrogen ions will be deposited on the silicon substrate 3, further attracting sputtered aluminum and ionized nitrogen. Hereby, the growth of an epilayer of AIN on the silicon substrate is promoted.

The power of said DC bias may be pulsed with a frequency in a range from and including 10 kHz to and including 350 kHz. The pulsing is performed in duty cycles in a range from and including 1% to and including 10%. The total pressure in the process chamber during sputtering may be less than 7.5 mTorr (1 Pa). The positive bias may be in the range from and including 1 kV to and including 5 kV. The positive bias may as such be 1 kV, or 2 kV, or 3 kV, or 4 kV, or 5 kV. The positive bias may be applied as a DC bias. The DC bias may be pulsed with a frequency in a range from and including 10 kHz to and including 350 kHz.

The substrate may be heated to a temperature in the range of 600 to 1200 °C. The crystallinity of the aluminum nitride is enhanced by sublimation of the Al-N getter to a crystalline solid thin-film. This is achieved by applying a DC bias power with the glow discharge reaching the electron temperature of 10 eV, which is equivalent to 10000 K. For example, the total DC power may be in the range of 900-1500 W. A duty cycle may be used to provide pulses with high power densities of the order of kW/cm2 in short pulses (impulses) of tens of microseconds at low duty cycle of < 10%. In another embodiment of the invention the pressure is reduced to 1 mTorr to further increase the kinetic energy of the argon ions. A high diffusion on the surface of the silicon substrate may be provided with a temperature higher than 500°C. It is preferred that the temperature is equal or higher than 700°C. However, the temperature preferably should not exceed 1000°C, so as to prevent the alloy formation between gallium and silicon. For AC sputtering, the polarity is changed in a half cycle from plus to minus at a typical frequency of 13.56 MHz corresponding to a period of 71 ns. A DC Sputtering system typically requires between 2 to 5kV. The anode / target is cleared of charge during the off time and deposits material during the negative cycle.

Prior to depositing an epilayer of aluminum and nitrogen on the silicon substrate 4, the silicon substrate 4 may be surface treated to increase the surface smoothness thereof. For example, the silicon substrate 4 may be sputtered by the noble gas before or during the aluminum target 3 is sputtered. Alternatively, the silicon substrate 4 may be wet etched in HF prior to the silicon substrate 4 being arranged in the process chamber 2. The time between sputtering the silicon substrate 4 or wet etching the silicon substrate 4 and depositing a getter of aluminum and nitrogen on the silicon substrate 4 is preferably less than 20 minutes.

The method according to the first aspect of the present invention may be used to provide a gallium nitride semiconductor transition layer structure.

The silicon substrate may have a crystallographic direction of <111>. Specifically, the gallium nitride semiconductor transition layer structure may comprise a silicon substrate 4 having a crystallographic direction of <111>, and a polycrystalline epilayer of aluminum and nitrogen disposed on and above the silicon substrate, the epilayer being obtained by a method according to the first aspect of the present invention. The polycrystalline AIN epilayer comprises a pillar nanostructure that has an epitaxial relationship to the silicon substrate 4. The epilayer of aluminum and nitrogen may comprise a first 3C-AIN epilayer of a thickness less than 5 nm in direct contact with said silicon substrate 4, and a 2H-AIN epilayer with a thickness in the range of 100 - 500 nm in direct contact with said 3C-AIN epilayer. The pillar nanostructure may have a thickness in the range of 10 - 60 nm.

Another embodiment of the invention is a GaN-on-Silicon epiwafer that comprises a polycrystalline epilayer of aluminum and nitrogen disposed on and above the silicon substrate. The first layer disposed on and above the substrate of polycrystalline AIN epilayer comprises a pillar nanostructure that has an epitaxial relationship to the silicon substrate 4. The epilayer of aluminum and nitrogen may comprise a first 3C-AIN epilayer of a thickness less than 5 nm in direct contact with said silicon substrate 4, and a 2H-AIN epilayer with a thickness in the range of 100 - 500 nm in direct contact with said 3C-AIN epilayer. The pillar nanostructure may have a thickness in the range of 10 - 60 nm, 100 - 300 nm or 300 - 1000 nm. On the polycrystalline AIN epilayer a second epilayer comprising AI(x)Ga(1-x)N with the composition 0.2≤x<0.3, may be deposited by MOCVD. A third epilayer of AI(y)Ga(1-y)N with the composition 0.1 ≤x<0.2, may be deposited by MOCVD, and a fourth substantially thick GaN epilayer may be deposited by MOCVD.

A presently preferred embodiment of the invention is a method for depositing AIN on a silicon substrate arranged in a process chamber, the method comprising: arranging an aluminum target in said process chamber; providing a process gas composition comprising a noble gas and nitrogen to said process chamber; ionizing said process gas composition by providing an electric field and a magnetic field such that a getter of noble gas ions and nitrogen ions is formed; sputtering said aluminum target while applying a positive bias on the silicon substrate; and depositing an epilayer of aluminum and nitrogen on the silicon substrate. The silicon substrate may have a crystallographic direction of <111>. The process gas composition, when provided to said process chamber, may have a total pressure of less than 2 mTorr. The silicon substrate and the aluminum target may be substantially parallel and arranged at a distance in a range from and including 1 cm to and including 10 cm from each other. The positive bias may be applied as a DC bias. The DC bias may be applied with a power in the range of 900 to 1500 W. The power of said DC bias may be pulsed with a frequency in a range from and including 10 kHz to and including 350 kHz. The pulsing is performed in duty cycles in a range from and including 1% to and including 10%. The total pressure in the process chamber during sputtering may be less than 7.5 mTorr (1 Pa).

Sputtering of said silicon substrate may be performed by said noble gas before sputtering said aluminum target. The silicon substrate may be wet etched in HF prior to said silicon substrate being arranged in said process chamber. The time between sputtering said silicon substrate or wet etching said silicon substrate and depositing an epilayer of aluminum and nitrogen on the silicon substrate may be less than 20 minutes. The sputtering may be performed with said aluminum target coaxial to said substrate. The process gas composition may comprise argon, and the ratio of nitrogen to argon may be in the range of 1:1 to 1:3. The process gas composition may comprise argon, wherein a partial pressure of nitrogen may be in the range of 0.2 to 0.3 mTorr and a partial pressure of argon is in the range of 0.1 mTorr to 3 mTorr. The substrate may be heated to a temperature in the range of 600 to 1200 °C.

Another presently preferred embodiment of the invention is a gallium nitride semiconductor transition layer structure, comprising: a silicon substrate having a crystallographic direction of <111>; a polycrystalline epilayer of aluminum and nitrogen disposed on and above said silicon substrate. The polycrystalline AIN epilayer may comprise a pillar nanostructure having an epitaxial relationship to said substrate. The epilayer of aluminum and nitrogen may comprise a first 3C-AIN epilayer of a thickness less than 5 nm in direct contact with said silicon substrate, and a 2H-AIN epilayer with a thickness in the range of 100 - 500 nm in direct contact with said 3C-AIN epilayer. The pillar nanostructure may have a thickness in the range of 10-60 nm.

Another presently preferred embodiment of the invention is a GaN-on-Silicon epiwafer that comprises a polycrystalline epilayer of aluminum and nitrogen disposed on and above the silicon substrate. The first layer may be disposed on and above the substrate of polycrystalline AIN epilayer comprises a pillar nanostructure that has an epitaxial relationship to the silicon substrate 4. The epilayer of aluminum and nitrogen may comprise a first 3C-AIN epilayer of a thickness less than 5 nm in direct contact with said silicon substrate 4, and a 2H-AIN epilayer with a thickness in the range of 100 - 500 nm in direct contact with said 3C-AIN epilayer. The pillar nanostructure may have a thickness in the range of 10 - 60 nm, 100 - 300 nm or 300 - 1000 nm. The polycrystalline AIN epilayer may comprise a second epilayer disposed on said first layer comprising AI(x)Ga(1-x)N with the composition 0.2≤x<0.3, may be deposited by MOCVD. A third epilayer of AI(y)Ga(1-y)N with the composition 0.1≤x<0.2, may be deposited by MOCVD, and a fourth substantially thick GaN epilayer may be deposited by MOCVD. Alternatively, the polycrystalline AIN epilayer may comprise a second epilayer disposed on said first layer comprising GaN deposited by MOCVD. A third epilayer of AI(x)Ga(1-x)N may be disposed on said second epilayer with the composition 0<x<1 deposited by MOCVD having a thickness in the range 1-30 nm.

Although modifications and changes may be suggested by those skilled in the art, it is the intent of the inventor to, within the scope of the disclosure herein, that the invention encompasses the scope of all modifications and modifications which reasonably and properly fall within the scope of the disclosure disclosed herein. The present invention has been described above with reference to specific embodiments. However, other embodiments than the above described are equally possible within the scope of the invention. Different method steps than those described above for the method of depositing AIN on a silicon substrate may be provided within the scope of the invention. The different features and steps of the invention may be combined in other combinations than those described. For example, various features of embodiments may be combined in combinations other than those described mutatis mutandis. The scope of the invention is limited only by the appended claims.

## Claims

1. A method for depositing AIN on a silicon substrate (4) arranged in a process chamber (2), the method comprising:
arranging an aluminum target (3) in said process chamber (2);
providing a process gas composition comprising a noble gas and nitrogen to said process chamber (2);
ionizing said process gas composition by providing an electric field and a magnetic field such that a getter of noble gas ions and nitrogen ions is formed;
sputtering said aluminum target (3) while applying a positive bias on the silicon substrate (4); and
depositing an epilayer of aluminum and nitrogen on the silicon substrate (4).

2. The method according to claim 1, wherein the silicon substrate (4) has a crystallographic direction of <111>.

3. The method according to any preceding claim, wherein the process gas composition, when provided to said process chamber (2), has a total pressure of less than 2 mTorr.

4. The method according to any preceding claim, wherein the silicon substrate (4) and the aluminum target (3) are substantially parallel and arranged at a distance in a range from and including 1 cm to and including 10 cm from each other.

5. The method according to any preceding claim, wherein the positive bias is applied as a DC bias, preferably with a power in the range of 900 to 1500 W and preferably as a pulsed DC bias with a frequency in a range from and including 10 kHz to and including 350 kHz.

6. The method according to any one of the preceding claims, wherein a total pressure in the process chamber (2) during sputtering is less than 7.5 mTorr (1 Pa).

7. The method according to any one of the preceding claims, further comprising sputtering said silicon substrate (4) by said noble gas before sputtering said aluminum target (3).

8. The method according to any one of the preceding claims, further comprising wet etching said silicon substrate (4) in HF prior to said silicon substrate (4) being arranged in said process chamber (2).

9. The method according to claim 7 or 8, wherein a time between sputtering said silicon substrate (4) or wet etching said silicon substrate (4) and depositing an epilayer of aluminum and nitrogen on the silicon substrate (4) is less than 20 minutes.

10. The method according to any one of the preceding claims, wherein said aluminum target (3) is coaxial to said silicon substrate (4).

11. The method according to any preceding claims, wherein the process gas composition comprises argon, and wherein a ratio of nitrogen to argon is in the range of 1:1 to 1:3.

12. The method according to any preceding claims, wherein the process gas composition comprises argon, and wherein a partial pressure of nitrogen is in the range of 0.2 to 0.3 mTorr and a partial pressure of argon is in the range of 0.1 mTorr to 3 mTorr.

13. The method according to any preceding claims, further comprising heating the substrate to a temperature in the range of 600 to 1200 °C.

14. A gallium nitride semiconductor transition layer structure, comprising:
a silicon substrate (4) having a crystallographic direction of <111>;
a polycrystalline epilayer of aluminum and nitrogen disposed on and above said silicon substrate (4), said epilayer being obtained by a method according to any one of claims 1 to 13;
wherein said polycrystalline AIN epilayer comprises a pillar nanostructure having an epitaxial relationship to said substrate (4).

15. The gallium nitride semiconductor transition layer structure according to claim 14, wherein said epilayer of aluminum and nitrogen comprises a first 3C-AIN epilayer of a thickness less than 5 nm in direct contact with said silicon substrate (4), and a 2H-AIN epilayer with a thickness in the range of 100 - 500 nm in direct contact with said 3C-AIN epilayer, and/or wherein said pillar nanostructure has a thickness in the range of 10 - 60 nm.

## Amended claims

### Amended claims in accordance with Rule 137(2) EPC.

1. A method for depositing AIN on a silicon substrate (4) arranged in a process chamber (2), the method comprising:
arranging an aluminum target (3) in said process chamber (2);
providing a process gas composition comprising a noble gas and nitrogen to said process chamber (2);
ionizing said process gas composition by providing an electric field and a magnetic field such that a getter of noble gas ions and nitrogen ions is formed;
sputtering said aluminum target (3) while applying a positive bias on the silicon substrate (4);
depositing an epilayer of aluminum and nitrogen on the silicon substrate (4); and
sputtering said silicon substrate (4) by said noble gas before sputtering said aluminum target (3).

2. The method according to claim 1, wherein the silicon substrate (4) has a crystallographic direction of <111>.

3. The method according to any preceding claim, wherein the process gas composition, when provided to said process chamber (2), has a total pressure of less than 2 mTorr.

4. The method according to any preceding claim, wherein the silicon substrate (4) and the aluminum target (3) are substantially parallel and arranged at a distance in a range from and including 1 cm to and including 10 cm from each other.

5. The method according to any preceding claim, wherein the positive bias is applied as a DC bias, preferably with a power in the range of 900 to 1500 W and preferably as a pulsed DC bias with a frequency in a range from and including 10 kHz to and including 350 kHz.

6. The method according to any one of the preceding claims, wherein a total pressure in the process chamber (2) during sputtering is less than 7.5 mTorr (1 Pa).

7. The method according to any one of the preceding claims, further comprising wet etching said silicon substrate (4) in HF prior to said silicon substrate (4) being arranged in said process chamber (2).

8. The method according to claim 7, wherein a time between wet etching said silicon substrate (4) and depositing an epilayer of aluminum and nitrogen on the silicon substrate (4) is less than 20 minutes.

9. The method according to claim 1, wherein a time between sputtering said silicon substrate (4) and depositing an epilayer of aluminum and nitrogen on the silicon substrate (4) is less than 20 minutes.

10. The method according to any one of the preceding claims, wherein said aluminum target (3) is coaxial to said silicon substrate (4).

11. The method according to any preceding claims, wherein the process gas composition comprises argon, and wherein a ratio of nitrogen to argon is in the range of 1:1 to 1:3.

12. The method according to any preceding claims, wherein the process gas composition comprises argon, and wherein a partial pressure of nitrogen is in the range of 0.2 to 0.3 mTorr and a partial pressure of argon is in the range of 0.1 mTorr to 3 mTorr.

13. The method according to any preceding claims, further comprising heating the substrate to a temperature in the range of 600 to 1200 °C.

14. A gallium nitride semiconductor transition layer structure, comprising:
a silicon substrate (4) having a crystallographic direction of <111>;
a polycrystalline epilayer of aluminum and nitrogen disposed on and above said silicon substrate (4), said epilayer being obtained by a method according to any one of claims 1 to 13;
wherein said polycrystalline AIN epilayer comprises a pillar nanostructure having an epitaxial relationship to said substrate (4); and
wherein said epilayer of aluminum and nitrogen comprises a first 3C-AIN epilayer of a thickness less than 5 nm in direct contact with said silicon substrate (4), and a 2H-AIN epilayer with a thickness in the range of 100 - 500 nm in direct contact with said 3C-AIN epilayer, and/or wherein said pillar nanostructure has a thickness in the range of 10 - 60 nm.
